# EUROPÄISCHE PATENTSCHRIFT

(11) **EP 2 535 736 B1**
(45) Veröffentlichungstag und Bekanntmachung des Hinweises auf die Patenterteilung: **04.05.2016**
(21) Anmeldenummer: 12168075.5
(22) Anmeldetag: 15.05.2012
(51) Int. Cl.: G01S 15/93, G01S 7/529

(54) **Verfahren und Vorrichtung zum Verstärken eines zur Fahrzeugumfelddetektion geeigneten Echosignals**
Method and device for reinforcing an echo signal suitable for detecting the surroundings of vehicles
Procédé et dispositif destinés à renforcer un signal d'écho adapté à la détection de l'environnement d'un véhicule

(30) Priorität: 16.06.2011 DE 102011077578
(43) Veröffentlichungstag der Anmeldung: 19.12.2012
(73) Patentinhaber: ROBERT BOSCH GMBH, 70442 Stuttgart (DE)
(72) Erfinder: Karl, Matthias, 76275 Ettlingen (DE)

(56) Entgegenhaltungen:
- DE-A1-102008 054 789
- US-A- 4 416 153
- US-A- 5 677 666

## Beschreibung

### Stand der Technik

Die vorliegende Erfindung betrifft ein Verfahren und eine Vorrichtung zum Verstärken eines zur Fahrzeugumfelddetektion geeigneten Echosignals. Auch betrifft die Erfindung ein Fahrzeugassistenzsystem mit einer erfindungsgemäßen Vorrichtung zum Verstärken eines zur Fahrzeugumfelddetektion geeigneten Echosignals.

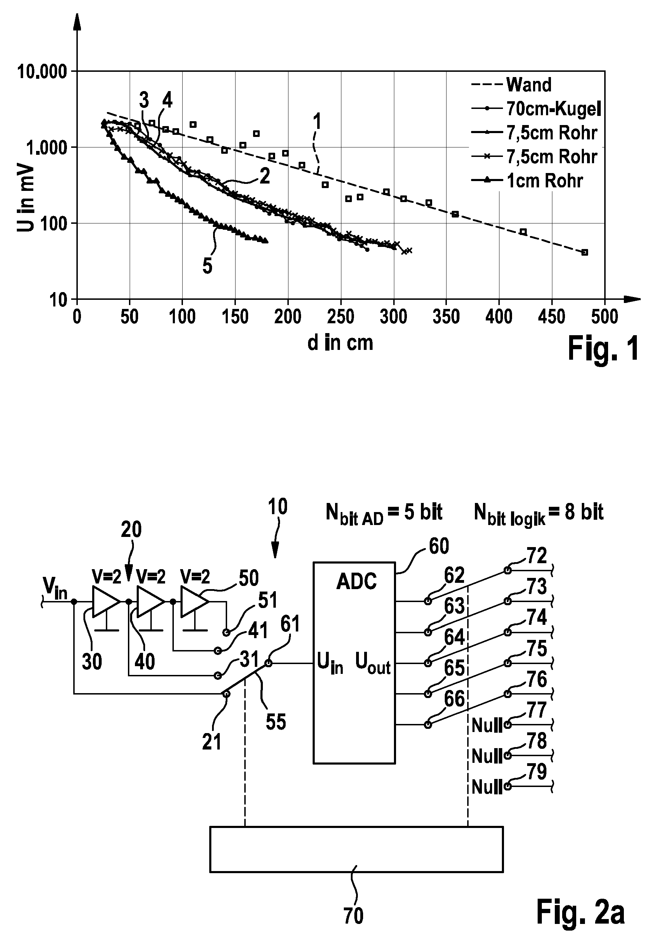

Figur 1 zeigt verschiedene in mV gemessene Spannungssignale 1 bis 5, die eine mit der Entfernung abnehmende Amplitude von an verschiedenen Objekte reflektierten Echopulsen für pulsweise messende umfeldsensierende Systeme wie Ultraschallsensorik zeigen. Dabei wurde als Maß für die Entfernung bzw. Echolaufzeit der in cm gemessenen Echopulsabstand d gewählt.

Aus der Figur 1 wird deutlich, dass zu jedem Zeitpunkt der Echolaufzeit, zwischen der Amplitude einer als reflexionsstärkstes Objekt angenommenen Wand und der Amplitude eines zumeist als reflexionsschwächstes Objekt angenommenen 1cm-Rohrs stets ein Verhältnis zwischen 16 und 32 herrscht, was beispielsweise einem effektiven Signaldynamikbereich von N_{bit Signal_gesamt} ≤ 5 bit entspricht. In der Praxis genügt daher zumeist ein A/D-Wandler mit einer Auflösung von z.B. N_{bit ADC} = N_{bit Signal_effektiv}, um zu einem Zeitpunkt alle möglichen Amplituden in ein Digitalsignal zu wandeln.

Figur 1 zeigt auch, dass das Signal während der gesamten Echolaufzeit, d.h., während des Messbereichs des Echoabstands bis ca. 400cm, einen Gesamtdynamikbereich von z.B. N_{bit Signal_gesamt} = 8 bit aufweist.

Aus dem Dokument DE 10 2008 054 789 A1 ist ein Verfahren zum Verstärken eines zur Fahrzeugumfelddetektion geeigneten Echosignals bekannt, bei dem ein Verstärkungsfaktor abhängig von einer Laufzeit des Echosignals eingestellt wird. Hierzu ist ein variabler Verstärker vorgesehen, wobei die Verstärkungskurve auch einen sprunghaften Verlauf in mehreren Schritten aufweisen kann. Als Ausführungsbeispiel ist eine aufwändige Operationsverstärkerschaltung mit durch Zuschalten und Abschalten von Widerständen sprunghafter Verstärkungsumschaltung gezeigt. Es ist ebenfalls beschrieben, dass der Verlauf der sprunghaften Verstärkungsänderung durch eine zentrale Signalverarbeitung zusätzlich einkalibriert werden muss.

Aus demselben Dokument wird deutlich wie der Auswerteaufwand bei moderneren Systemen mittels laufzeitabhängiger Verstärkung reduziert werden kann. Praktisch bedeutet das, dass der Gesamtdynamikbereich N_{bit Signal_gesamt} auf einen in der nachfolgenden Logik spürbaren effektiven Dynamikbereich von N_{bit Logik_effektiv} reduziert wird.

Häufig stehen jedoch vorgefertigte Rechnerkerne für die Realisierung von Binärlogik mit standardisierten Auswertebreiten N_{bit Logik_effektiv} von z.B. 8 bit zur Verfügung. Die Komprimierung der in der Logik spürbaren Signaldynamik auf N_{bit Signal_effektiv} mittels laufzeitabhängiger Verstärkung ist daher in solchen Fällen nicht zwingend erforderlich. Aufwändig ist bei solchen Systemen jedoch der erforderliche Dynamikbereich des AD-Wandlers, insbesondere wenn er als Flash-AD-Wandler ausgeführt ist. Jedes Bit mehr Signaldynamik potenziert den Rechenaufwand.

Ferner ist aus dem Dokument US 5,677,666 A ein Verfahren zur Innenraumüberwachung eines Kraftfahrzeuges mittels von Schallwellen bekannt. Dabei werden zur Innenraumüberwachung ausgesendete Schallwellen, auf denen aus Reflektionen der ausgesendeten Schallwellen stammenden Echos überlagert sind, empfangen und in analoge elektrische Messsignale umgewandelt. Die analogen Messsignale werden verstärkt, mittels eines A/D-Wandlers digitalisiert und mittels einer mit dem A/D-Wandler verbundenen zentralen Recheneinheit ausgewertet.

### Offenbarung der Erfindung

Erfindungsgemäß wird ein Verfahren zum Verstärken eines zur Fahrzeugumfelddetektion geeigneten Echosignals bereitgestellt, bei dem das analoge Echosignal mit einer von der Laufzeit des Echosignal abhängigen Verstärkung verstärkt wird und eine Digitalisierung des analogen Echosignals mittels eines mit einer zeitkonstanten Referenzspannung betriebenen A/D-Wandlers erfolgt, der einen Dynamikbereich aufweist, der kleiner als der Dynamikbereich einer nachfolgenden Digitallogik ist, auf den der Gesamtdynamikbereich des analogen Echosignals abgebildet wird. Dabei werden die Ausgänge des A/D-Wandlers entsprechend der Verstärkung des Echosignals mit entsprechenden Eingängen einer nachfolgenden Digitallogik verbunden.

Erfindungsgemäß wird weiterhin eine Vorrichtung zum Verstärken mindestens eines zur Fahrzeugumfelddetektion geeigneten Echosignals bereitgestellt, die einen Verstärker zum Verstärken des analoge Echosignals mit einer zeitabhängigen Verstärkung und ein mit einer zeitkonstanten Referenzspannung betriebenen A/D-Wandler aufweist, der zum Digitalisieren des analogen Echosignals ausgebildet ist und einen Dynamikbereich aufweist, der kleiner als der Dynamikbereich einer nachfolgenden Digitallogik ist, auf den der Gesamtdynamikbereich des analogen Echosignals abzubilden ist. Ferner weist die Vorrichtung eine Steuerung auf, die dazu ausgebildet ist, die Ausgänge des A/D-Wandlers entsprechend der Verstärkung des Echosignals mit entsprechenden Eingängen einer nachfolgenden Digitallogik zu verbinden.

Die Unteransprüche zeigen bevorzugte Weiterbildungen der Erfindung.

Bei dem erfindungsgemäßen Verfahren wird durch eine von der Laufzeit des Echosignal abhängige Verstärkung der Gesamtdynamikbereich des analogen Echosignals auf einen kleineren effektiven Gesamtdynamikbereich reduziert, was zu einer erhebliche Reduzierung des erforderlichen Rechenaufwands führt. Die Abbildung des Gesamtdynamikbereichs des analogen Echopulses auf einen kleineren effektiven Gesamtdynamikbereich erfolgt erfindungsgemäß in einfacher und kostengünstiger Weise, indem die Ausgänge eines mit einer zeitkonstanten Referenzspannung betriebenen und zur Digitalisierung des analogen Echopulses verwendeten A/D-Wandlers entsprechend der Verstärkung des Echosignals mit entsprechenden Eingängen einer nachfolgenden Digitallogik verbunden werden.

Eine weitere Reduzierung des erforderlichen Rechenaufwands erfolgt erfindungsgemäß in einfacher Weise durch die Verwendung eines kostengünstigen A/D-Wandlers mit geringer Bitbreite, der einen Dynamikbereich aufweist, der kleiner als der effektive Gesamtdynamikbereich des Echosignals ist.

Insbesondere wird das analoge Echosignal mittels eines Verstärkers mit einer Vielzahl von Ausgängen mit unterschiedlichen Verstärkungen verstärkt und zur

Erzeugung einer zeitabhängigen Verstärkung des analogen Echosignals mindestens ein Eingang des A/D-Wandlers nacheinander mit mehreren oder allen Ausgängen des Verstärkers verbunden. Durch die Verwendung eines Verstärkers mit einer Vielzahl von Ausgängen mit unterschiedlichen Verstärkungen, die nacheinander abhängig von der zu einem jeweiligen Zeitpunkt gewünschten Verstärkung mit mindestens einem Eingang des A/D-Wandlers verbunden werden, wird in einfacher Weise und ohne eine Verwendung komplexer und kostenintensiver elektronischer Bauelemente eine zeitabhängige Verstärkung des analogen Echopulses erzeugt.

In einer besonders vorteilhaften Ausführungsform der Erfindung wird das analoge Echosignal mittels einer in Reihe geschalteten Kette von Verstärkern insbesondere fester Verstärkung verstärkt.

Erfindungsgemäß wird ferner ein einfach und kostengünstig realisierbares Verfahren zur Fahrzeugumfelddetektion mittels mindestens eines Echosignals bereitgestellt, bei dem mindestens ein Echosignal mittels eines Verfahrens nach mindestens einem der vorangehenden Ansprüche verstärkt und zumindest das mindestens eine verstärkte Echosignal zur Fahrzeugumfelddetektion ausgewertet.

Weiterhin wird erfindungsgemäß ein kostengünstiges Fahrzeugassistenzsystem zur Fahrzeugumfelddetektion mit einer erfindungsgemäßen Vorrichtung zum Verstärken mindestens eines zur Fahrzeugumfelddetektion geeigneten Echosignals bereitgestellt, das eine Auswerteeinheit zur Fahrzeugumfelddetektion zumindest durch ein mittels der erfindungsgemäßen Vorrichtung verstärktes und/oder nicht verstärktes Echosignal umfasst.

### Kurze Beschreibung der Zeichnungen

Nachfolgend werden Ausführungsbeispiele der Erfindung unter Bezugnahme auf die begleitende Zeichnung im Detail beschrieben. In der Zeichnung ist:
- Figur 1: ein Diagramm, das verschiedene von dem Echopulsabstand abhängige Spannungssignale darstellt, die eine mit der Entfernung abnehmende Amplitude von an verschiedenen Objekten reflektierten Echopulsen für pulsweise messende umfeldsensierende Systeme nach der Stand der Technik zeigen,
- Figur 2a bis 2d: ein Blockschaltbild einer erfindungsgemäßen Vorrichtung zum Verstärken mindestens eines zur Fahrzeugumfelddetektion geeigneten Echosignals nach einer ersten Ausführungsform der Erfindung in vier verschiedene Beschaltungspositionen und
- Figur 3a bis 3b: ein Blockschaltbild einer erfindungsgemäßen Vorrichtung zum Verstärken mindestens eines zur Fahrzeugumfelddetektion geeigneten Echosignals nach einer zweiten Ausführungsform der Erfindung in zwei verschiedene Beschaltungspositionen.

### Ausführungsformen der Erfindung

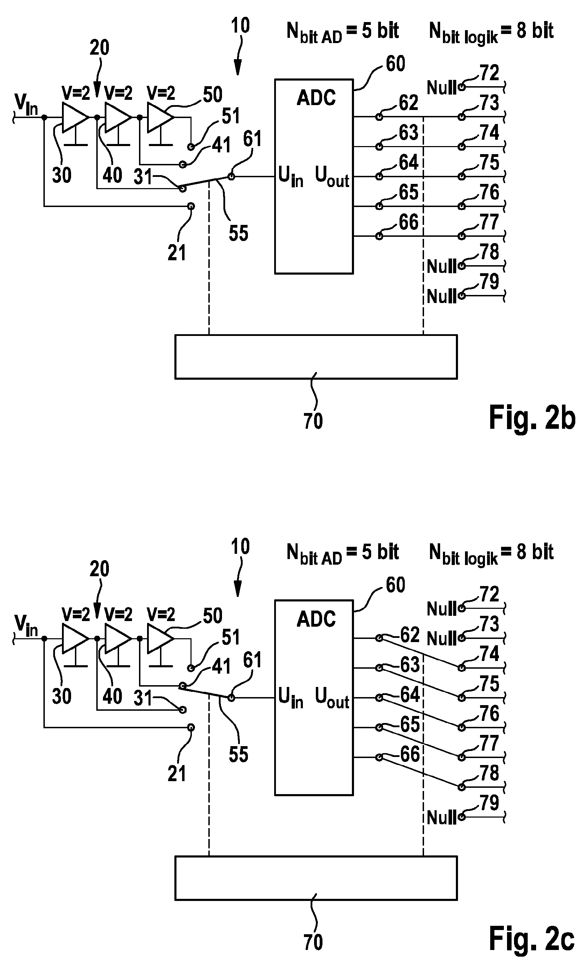

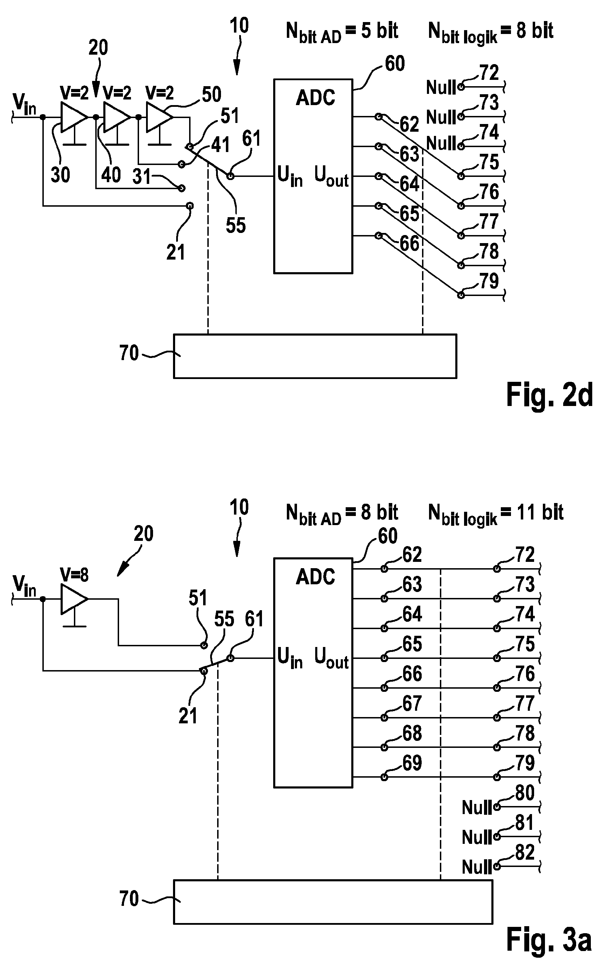

In den Figuren Figur 2a bis 2d ist ein Blockschalt einer erfindungsgemäßen Vorrichtung 10 zum Verstärken mindestens eines zur Fahrzeugumfelddetektion geeigneten Echosignals rᵢₙ nach einer ersten Ausführungsform der Erfindung in vier verschiedene Beschaltungspositionen dargestellt.

Das analoge Eingangsignal (Echosignal) rᵢₙ wird mittels eines Verstärkers 20 verstärkt. Der Verstärker 20 umfasst eine Kette in Reihe geschalteter Verstärker 30, 40, 50 insbesondere fester Verstärkung V. Für die Verstärkung V kann beispielsweise der Wert 2 ausgewählt werden. Der Verstärker 10 umfasst mehrere Ausgänge 21, 31, 41, 51 mit unterschiedlichen Verstärkungen.

Dem Verstärker 20 nachgeschaltet ist ein mit zeitkonstanter Referenzspannung betriebener A/D-Wandler 60 (ADC), der einen Eingang 61 (Uᵢₙ) und fünf Ausgänge 62, 63, 64, 65, 66 (Uₒᵤₜ) aufweist. Der A/D-Wandler 60 hat eine Dynamik N_{bit_ADC} von 5 bit. Der Eingang 61 des A/D-Wandlers 60 kann mittels einem über eine Steuerung 70 gesteuerten Analogschalter 55 mit jeweils einem Ausgang 21, 31, 41, 51 des Verstärkers 20 verbunden werden. Die Ausgänge 62, 63, 64, 65, 66 des A/D-Wandlers 60, können über die Steuerung 70 gesteuert, jeweils mit entsprechenden Eingängen 72, 73, 74, 75, 76, 77, 78, 79 einer nachfolgenden Digitallogik (nicht dargestellt) verbunden werden, wodurch der Gesamtdynamikbereich N_{bit_Signal_gesamt} des analogen Eingangsignals rᵢₙ auf den verfügbaren Dynamikbereich N_{bit_Logik} von 8 bit abgebildet wird.

In den Figuren 2a bis 2d ist also die Grundarchitektur der erfindungsgemäße Vorrichtung 10 nach der ersten Ausführungsform der Erfindung beispielsweise für eine A/D-Wandlerdynamik N_{bit_ADC} von 5 bit und eine zur Abbildung des Gesamtbereichs N_{bit_Signal_gesamt} des analogen Eingangssignal rᵢₙ verfügbare Dynamik N_{bit_Logik} der nachfolgenden Digitallogik von 8 bit in den vier durch die Steuerung 70 festlegbaren Beschaltungsvarianten dargestellt, die abhängig von einer Sendebeginninformation echolaufzeitabhängig variiert werden können.

Das analoge Eingangssignal rᵢₙ kann eine Frequenz im Frequenzbereich von z.B. ca. 48 kHz aufweisen und wird insbesondere durch die Steuerung 70 mittels eines Analogschalters 55 wahlweise um ein Vielfaches von 2^{x} verstärkt bevor es auf den A/D-Wandlereingang 61 gelangt. Die Steuerung 70 sorgt auch dafür, dass die fünf A/D-Wandlerausgänge 62 bis 66 je nach Eingangsbeschaltung des A/D-Wandlers 60 auf die entsprechenden Leitungen 72 bis 79 der weiterverarbeitenden Digitallogik gelegt werden und dass die übrigen Leitungen 72 bis 79 der weiterverarbeitenden Digitallogik entsprechend mit "Null" belegt werden.

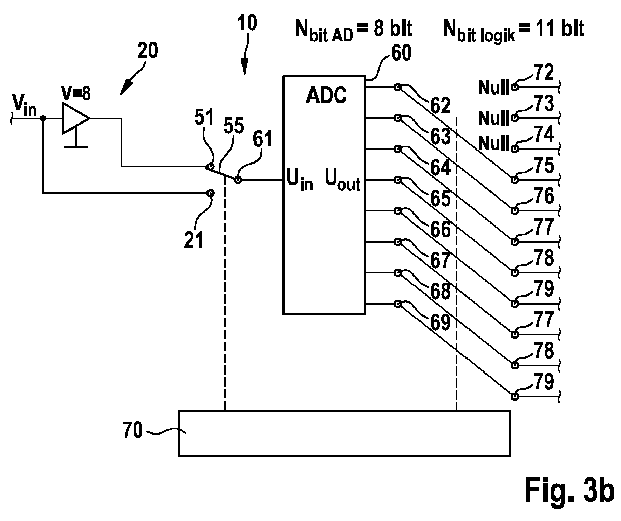

In den Figuren Figur 3a und 3b ist ein Blockschaltbild einer erfindungsgemäßen Vorrichtung 10 zum Verstärken mindestens eines zur Fahrzeugumfelddetektion geeigneten Echosignals rᵢₙ nach einer zweiten Ausführungsform der Erfindung in zwei verschiedene Beschaltungspositionen dargestellt.

Die Vorrichtung 10 nach der zweiten Ausführungsform der Erfindung umfasst genau einen Nachverstärker 20 mit einer Verstärkung von 8 sowie einen A/D-Wandler mit acht Ausgängen 62, 63, 64, 65, 66, 67, 68, 69 und einer Dynamik N_{bit_ADC} von 8 bit, der auf einen Gesamtdynamikbereich N_{bit_Logik} von 11 bit der nachfolgenden Digitallogik (nicht dargestellt) abgebildet wird. Die Digitallogik hat in diesem Ausführungsbeispiel elf Eingänge 72, 73, 74, 76, 77, 78, 79, 80, 81, 82.

Verwendet die auswertende Digitallogik nach dem zweiten Ausführungsbeispiel der Erfindung eine Verarbeitungsbreite von 16 bit, so bleibt ihr eine Dynamik von 5 bit für Arithmetiken, ohne dass diese Arithmetiken eine Überlaufkontrolle durchführen müssen.

Dieses Prinzip ist nicht nur für pulsweise messende umfeldsensierende Systemen wie Ultraschallsensorik, sondern auch für kontinuierlich messende Systeme geeignet, wenn z.B. der effektive Dynamikbereich N_{bit_Signal_effektiv} des analogen Eingangssignals rᵢₙ im Verhältnis zum Gesamtdynamikbereich N_{bit_Signal_gesamt} schwankt.

Erfindungsgemäß wird eine Architektur 10 bereitgestellt, die den gesamten Dynamikbereich N_{bit_Signal_gesamt} des analogen Eingangssignals rᵢₙ durch einen A/D-Wandler 60 mit geringerer Signaldynamik N_{bit_ADC} < N_{bit_Logik} in einen Dynamikbereich N_{bit_Logik} einer nachfolgenden Digitallogik abbildet.

Erfindungsgemäß bereitgestellt wird insbesondere eine besonders vorteilhafte Vorrichtung 10 zur Wandlung des Gesamtsignaldynamikbereichs N_{bit_Signal_gesamt} eines analogen Eingangssignals rᵢₙ in den Gesamtdynamikbereich N_{bit_Logik} einer das Analogsignal rᵢₙ digitalisierenden und weiterverarbeitenden Weise mit einer Dynamik von N_{bit_Logik} mittels eines A/D-Wandlers 60 mit einer Dynamik N_{bit_ADC} < N_{bit_Logik} derart, dass der Eingang 61 des mit zeitkonstanter Referenzspannung betriebenen A/D-Wandlers 60 durch eine das System steuernde Logik 70 zu gewissen Zeitpunkten T₁, T₂,...,T_{N} wahlweise an einen Ausgang 21 bis 51 oder 21, 51 der durch eine Kaskade von Verstärkungen verfügbaren Ausgängen 21 bis 51, die somit unterschiedliche Gesamtverstärkungswerte repräsentieren, mittels Analogschaltern 55 geschaltet wird und zu den gleichen Zeitpunkten T₁, T₂,...,T_{N} die Ausgänge 62 bis 66 oder 62 bis 69 des A/D-Wandlers 60 an entsprechende Eingänge 72 bis 79 oder 72 bis 82 der nachfolgenden Digitallogik verbunden werden.

Bei der hier beschriebenen Messbereichsnachführung wird insbesondere für Ultraschallsensorik einen Gesamtdynamikbereich N_{bit_Signal_gesamt} des analogen Eingangssignals rᵢₙ von 10 bis 11 bit, ein stark kostenbestimmender AD-Wandler 60 mit einer Dynamik N_{bit_ADC} von 5 bit und eine den Gesamtbereich N_{bit_Signal_gesamt} des analogen Eingangsignal rᵢₙ abbildende Digitallogik mit einem Dynamikbereich N_{bit_Logik} von 8 bit besonders bevorzugt.

## Patentansprüche

1. Verfahren zum Verstärken eines zur Fahrzeugumfelddetektion geeigneten Echosignals (rᵢₙ), bei dem ein analoges Echosignal (rᵢₙ) mit einer von der Laufzeit (T) des Echosignal abhängigen Verstärkung verstärkt wird, **dadurch gekennzeichnet, dass** eine Digitalisierung des analogen Echosignals (rᵢₙ) mittels eines mit einer zeitkonstanten Referenzspannung betriebenen A/D-Wandlers (60) erfolgt, der einen Dynamikbereich (N_{bit_ADC}) aufweist, der kleiner als der Dynamikbereich (N_{bit_Logik}) einer nachfolgenden Digitallogik ist, auf den der Gesamtdynamikbereich (N_{bit_Signal_gesamt}) des analogen Echosignals (rᵢₙ) abgebildet wird, und dessen Ausgänge (62,...,69) entsprechend der Verstärkung des Echosignals (rᵢₙ) mit entsprechenden Eingängen (72, ..., 82) der nachfolgenden Digitallogik verbunden werden.

2. Verfahren nach Anspruch 1, **dadurch gekennzeichnet, dass** das analoge Echosignal (rᵢₙ) mittels eines Verstärkers (20) mit einer Vielzahl von Ausgängen (21, 31, 41, 51) mit unterschiedlichen Verstärkungen verstärkt wird und zur Erzeugung einer zeitabhängigen Verstärkung des analogen Echosignals (rᵢₙ) mindestens ein Eingang (61) des A/D-Wandlers (60) nacheinander mit mehreren oder allen Ausgängen (21, 31, 41, 51) des Verstärkers (60) verbunden wird.

3. Verfahren nach einem der vorangehenden Ansprüche, **dadurch gekennzeichnet, dass** das analoge Echosignal (rᵢₙ) mittels einer in Reihe geschalteten Kette von Verstärkern (30, 40, 50) insbesondere fester Verstärkung (V) verstärkt wird.

4. Verfahren zur Fahrzeugumfelddetektion mittels mindestens eines Echosignals (rᵢₙ), bei dem mindestens ein analoges Echosignal (rᵢₙ) mittels eines Verfahrens nach einem der vorangehenden Ansprüche verstärkt wird und zumindest das verstärkte Echosignal (rᵢₙ) zur Fahrzeugumfelddetektion ausgewertet wird.

5. Vorrichtung (10) zum Verstärken mindestens eines zur Fahrzeugumfelddetektion geeigneten Echosignals (rᵢₙ), die einen Verstärker (20) zum Verstärken eines analogen Echosignals (rᵢₙ) mit einer zeitabhängigen Verstärkung aufweist, **gekennzeichnet durch** einen mit einer zeitkonstanten Referenzspannung betriebenen A/D-Wandler (60), der zum Digitalisieren des analogen Echosignals (rᵢₙ) ausgebildet ist und einen Dynamikbereich (N_{bit_ADC}) aufweist, der kleiner als der Dynamikbereich (N_{bit_Logik}) einer nachfolgenden Digitallogik ist, auf den der Gesamtdynamikbereich (N_{bit_Signal_gesamt}) des analogen Echosignals (rᵢₙ) abzubilden ist, und eine Steuerung (70), die dazu ausgebildet ist, die Ausgänge des A/D-Wandlers (60) entsprechend der Verstärkung des Echosignals (rᵢₙ) mit entsprechenden Eingängen (72,...,82) der nachfolgenden Digitallogik zu verbinden.

6. Vorrichtung (10) nach Anspruch 5, **dadurch gekennzeichnet, dass** der Verstärker (20) eine Vielzahl von Ausgängen (21, 31, 41, 51) mit unterschiedlichen Verstärkungen aufweist und die Steuervorrichtung (70) dazu ausgebildet ist, zur Erzeugung einer zeitabhängigen Verstärkung des analogen Echosignals (rᵢₙ) mindestens einen Eingang (61) des A/D-Wandlers (60) nacheinander mit mehreren oder allen Ausgängen (21, 31, 41, 51) des Verstärkers (20), insbesondere mittels mindestens eines Analogschalters (55), zu verbinden.

7. Vorrichtung (10) nach einem der Ansprüche 5 oder 6, **dadurch gekennzeichnet, dass** der Verstärker (20) eine in Reihe geschaltete Kette von Verstärkern (30, 40, 50) insbesondere fester Verstärkung (V) umfasst.

8. Fahrzeugassistenzsystem zur Fahrzeugumfelddetektion mit einer Vorrichtung (10) nach einem der Ansprüche 5 bis 7, **gekennzeichnet durch** eine Auswerteeinheit zur Fahrzeugumfelddetektion zumindest **durch** ein mittels der Vorrichtung (10) nach einem der Ansprüche 5 bis 7 verstärktes und/oder nicht verstärktes Echosignal (rᵢₙ).

## Claims

1. Method for amplifying an echo signal (rᵢₙ) that is suitable for vehicle surroundings detection, in which an analogue echo signal (rᵢₙ) is amplified using a gain that is dependent on the delay (T) in the echo signal, **characterized in that** the analogue echo signal (rᵢₙ) is digitized by means of an A/D converter (60) operated at a reference voltage that is constant over time, said A/D converter having a dynamic range (N_{bit_ADC}) that is smaller than the dynamic range (N_{bit_logic}) of a downstream digital logic unit, onto which dynamic range the total dynamic range (N_{bit_signal_total}) of the analogue echo signal (rᵢₙ) is mapped, and the outputs (62, ..., 69) of said A/D converter being connected to corresponding inputs (72, ..., 82) of the downstream digital logic unit in accordance with the gain of the echo signal (rᵢₙ).

2. Method according to Claim 1, **characterized in that** the analogue echo signal (rᵢₙ) is amplified by means of an amplifier (20) having a multiplicity of outputs (21, 31, 41, 51) having different gains, and a time-dependent gain for the analogue echo signal (rᵢₙ) is produced by connecting at least one input (61) of the A/D converter (60) to a plurality of or all outputs (21, 31, 41, 51) of the amplifier (60) in succession.

3. Method according to either of the preceding claims, **characterized in that** the analogue echo signal (rᵢₙ) is amplified by means of a series-connected chain of amplifiers (30, 40, 50), particularly of fixed gain (V).

4. Method for vehicle surroundings detection by means of at least one echo signal (rᵢₙ), in which at least one analogue echo signal (rᵢₙ) is amplified by means of a method according to one of the preceding claims and at least the amplified echo signal (rᵢₙ) is evaluated for the purpose of vehicle surroundings detection.

5. Apparatus (10) for amplifying at least one echo signal (rᵢₙ) that is suitable for vehicle surroundings detection, which has an amplifier (20) for amplifying an analogue echo signal (rᵢₙ) using a time-dependent gain, **characterized by** an A/D converter (60) operated at a reference voltage that is constant over time, said A/D converter being designed for digitizing the analogue echo signal (rᵢₙ) and having a dynamic range (N_{bit_ADC}) that is smaller than the dynamic range (N_{bit_logic}) of a downstream digital logic unit, onto which dynamic range the total dynamic range (N_{bit_signal_total}) of the analogue echo signal (rᵢₙ) can be mapped, and a controller (70) that is designed to connect the outputs of the A/D converter (60) to corresponding inputs (72, ..., 82) of the downstream digital logic unit in accordance with the gain of the echo signal (rᵢₙ).

6. Apparatus (10) according to Claim 5, **characterized in that** the amplifier (20) has a multiplicity of outputs (21, 31, 41, 51) having different gains and the control apparatus (70) is designed to produce a time-dependent gain for the analogue echo signal (rᵢₙ) by connecting at least one input (61) of the A/D converter (60) to a plurality of or all outputs (21, 31, 41, 51) of the amplifier (20) in succession, particularly by means of at least one analogue switch (55).

7. Apparatus (10) according to either of Claims 5 and 6, **characterized in that** the amplifier (20) comprises a series-connected chain of amplifiers (30, 40, 50), particularly of fixed gain (V).

8. Vehicle assistance system for vehicle surroundings detection having an apparatus (10) according to one of Claims 5 to 7, **characterized by** an evaluation unit for vehicle surroundings detection at least by virtue of an echo signal (rᵢₙ) that is amplified and/or not amplified by means of the apparatus (10) according to one of Claims 5 to 7.

## Revendications

1. Procédé de détection d'un signal d'écho (rin) approprié pour la détection de l'environnement d'un véhicule, dans lequel un signal d'écho analogique (rᵢₙ) est amplifié avec une amplification dépendant du temps de propagation (T) du signal d'écho,
**caractérisé en ce qu'**une numérisation du signal d'écho (rin) est effectuée au moyen d'un convertisseur A/N (60) attaqué avec une tension de référence constante dans le temps, lequel convertisseur présente une gamme dynamique (N_{bit_ADC}) qui est inférieure à la gamme dynamique (N_{bit_Logik}) d'une logique numérique connectée en aval, sur laquelle l'ensemble de la gamme dynamique (N_{bit_Signal_gesamt}) du signal d'écho analogique (rᵢₙ) est représentée et dont les sorties (62, ..., 69) sont connectées d'une manière qui correspond à l'amplification du signal d'écho (rᵢₙ) à l'entrée correspondante (72, ..., 82) de la logique numérique connectée en aval.

2. Procédé selon la revendication 1, **caractérisé en ce que** le signal d'écho analogique (rᵢₙ) est amplifié au moyen d'un amplificateur (20) comportant une pluralité de sorties (21, 31, 41, 51) ayant des amplifications différentes et **en ce qu'**au moins une entrée (61) du convertisseur A/N (60) est successivement connectée à plusieurs ou à la totalité des sorties (21, 31, 41, 51) de l'amplificateur (60) pour générer une amplification dépendant du temps du signal d'écho analogique (rᵢₙ).

3. Procédé selon l'une quelconque des revendications précédentes, **caractérisé en ce que** le signal d'écho analogique (rᵢₙ) est amplifié au moyen d'une chaîne connectée en série d'amplificateurs (30, 40, 50) ayant notamment une amplification fixe (V).

4. Procédé de détection de l'environnement d'un véhicule au moyen d'au moins un signal d'écho (rᵢₙ), dans lequel au moins un signal d'écho analogique (rᵢₙ) est amplifié au moyen d'un procédé selon l'une quelconque des revendications précédentes et au moins le signal d'écho amplifié (rᵢₙ) est évalué pour détecter l'environnement du véhicule.

5. Dispositif (10) destiné à amplifier au moins un signal d'écho (rᵢₙ) approprié pour la détection de l'environnement d'un véhicule, qui comprend un amplificateur (20) destiné à amplifier un signal d'écho analogique (rᵢₙ) avec une amplification dépendant du temps, **caractérisé par** un convertisseur A/N (60) attaqué avec une tension de référence constante dans le temps, lequel convertisseur est conçu pour numériser le signal d'écho analogique (rᵢₙ) et présente une gamme dynamique (N_{bit_ADC}) qui est inférieure à la gamme dynamique (N_{bit_Logik}) d'une logique numérique connectée en aval, sur laquelle l'ensemble de la gamme dynamique (N_{bit_signal_gesamt}) du signal d'écho analogique (rᵢₙ) doit être reproduite, et une unité de commande (70) qui est conçue pour connecter les sorties du convertisseur A/N (60) d'une manière qui correspond à l'amplification du signal d'écho (rᵢₙ), à des entrées correspondantes (72,..., 82) de la logique numérique connectée en aval.

6. Dispositif (10) selon la revendication 5,
**caractérisé en ce que** l'amplificateur (20) comprend une pluralité de sorties (21, 31, 41, 51) ayant des amplifications différentes et **en ce que** le dispositif de commande (70) est conçu pour connecter consécutivement au moins une entrée (61) du convertisseur A/N (60) à plusieurs ou à la totalité des sorties (21, 31, 41, 51) de l'amplificateur (20), notamment au moyen d'au moins un commutateur analogique (55), afin de générer une amplification dépendant du temps du signal d'écho analogique (rᵢₙ).

7. Dispositif (10) selon l'une quelconque des revendications 5 ou 6, **caractérisé en ce que** l'amplificateur (20) comprend une chaîne connectée en série d'amplificateurs (30, 40, 50) ayant notamment une amplification fixe (V).

8. Système d'aide à la conduite destiné à détecter l'environnement d'un véhicule comportant un dispositif (10) selon l'une quelconque des revendications 5 à 7, **caractérisé par** une unité d'évaluation destinée à détecter l'environnement du véhicule au moyen d'un signal d'écho (rᵢₙ) amplifié et/ou non amplifié au moyen du dispositif (10) selon l'une quelconque des revendications 5 à 7.
